# EUROPEAN PATENT SPECIFICATION

(11) **EP 4 202 986 B1**
(45) Date of publication and mention of the grant of the patent: **01.05.2024**
(21) Application number: 21216251.5
(22) Date of filing: 21.12.2021
(51) Int. Cl.: H01L 21/768, H01L 21/8238

(54) **VIA FORMATION IN AN INTEGRATED CIRCUIT**
HERSTELLUNG EINES VIAS IN EINER INTEGRIERTEN SCHALTUNG
FORMATION D'UNE INTERCONNEXION VERTICALE DANS UN CIRCUIT INTÉGRÉ

(43) Date of publication of application: 28.06.2023
(73) Proprietor: IMEC VZW, 3001 Leuven (BE)
(72) Inventor: CHAN, Boon Teik, 3012 Wilsele (BE); RADISIC, Dunja, 3001 Heverlee (BE); CHEHAB, Bilal, 3000 Leuven (BE)
(74) Representative: Winger

(56) References cited:
- US-A1- 2013 248 990
- US-A1- 2016 005 822
- US-A1- 2019 181 042

## Description

### Technical field of the invention

The present invention relates to the field of integrated circuits, and more in particular to a metallization scheme for forming an integrated circuit.

### Background of the invention

There is a constant drive to scale down integrated circuits. This translates into a need for reducing the size of the standard cell used in integrated circuits. In this respect, the type of transistor used and the way metal track lines are packed are key factors. In particular, the poly pitch (i.e., the pitch of successive transistor gates), the metal pitch (i.e., the pitch of successive metal track lines), and the cell height can, in principle, be minimized.

However, scaling poly pitch further becomes very challenging.

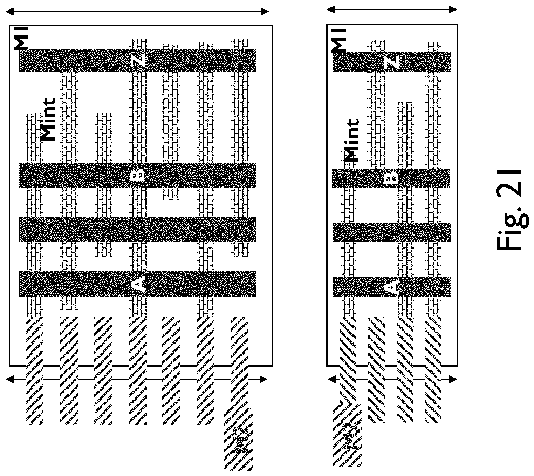

This has motivated recent attempts at reducing cell height. These attempts have reduced the height of the standard cell which has become more rectangular as a result. This is illustrated in Fig. 21. As can be readily observed, reducing the cell height also reduces the number of metal track lines per standard cell. This has an impact on how one can connect one circuit to another circuit on the wafer. Indeed, reducing the number of metal track lines per standard cell also reduces the routability of the lower metal layers of the standard cell due to high pin density, low pin accessibility, and limited routing resources.

For these reasons, the cell height remains stuck at the "five-track" level, i.e., a cell height that can vertically accommodate five tracks to access the pins.

US2019/181042A1, US2016/005822A1 and US2013/248990A1 disclose prior art methods and structures for forming self-aligned contacts and other interconnect features.

There is therefore a need in the art for new methods and systems to scale down integrated circuits.

### Summary of the invention

It is an object of the present invention to provide good systems or methods for forming an integrated circuit.

The above objective is accomplished by a method and device according to the present invention.

In a first aspect, the present invention relates to a method for forming an integrated circuit or an intermediate (15) in the formation thereof comprising the steps of:
a. Providing a semiconductor structure (16) comprising:
   i. two transistor structures (3a, 3b) separated by a dielectric separation (7), each transistor structure (3a, 3b) comprising a pMOS side (5p) of a first doping type and an nMOS side (5n) of a second doping type, each side forming a channel structure, a source portion, and a drain portion, the source portion and the drain portion being horizontally separated by said channel structure,
   ii. a gate structure on the channel structure, the gate structure comprising a gate electrode (1) and a gate plug (4),
   iii. electrically conductive contacts (MOA) electrically coupled to the source portion and the drain portion of each side (5p, 5n) of each transistor structure (3a, 3b),
   iv. a first dielectric layer (8) over the two transistor structures (3a, 3b), the gate structure, and the electrically conductive contacts (MOA),
   v. a first electrically conductive line (MOB) embedded in the first dielectric layer (8) so that a top surface (19) of the first electrically conductive line (MOB) and a top surface (20) of the first dielectric layer (8) are coplanar, the first electrically conductive line (MOB) being arranged within a first metallization level and extending along a first direction, the first electrically conductive line (MOB) extending above at least part of each transistor structure (3a, 3b),
   vi. a first electrically conductive via (V0A1) electrically connecting the first electrically conductive line (MOB) with a first electrically conductive contact (MOA1) on a first side (5n, 5p) of a first (3a) of the transistor structures (3a, 3b),
   vii. a second electrically conductive via (VOA2) electrically connecting the first electrically conductive line (MOB) with a second electrically conductive contact (MOA2) on a first side (5n, 5p) of a second (3b) of the transistor structures (3a, 3b),
b. optionally providing a protection (11) selectively on a top surface of the first electrically conductive line (MOB),
c. recessing the first dielectric layer (8) so as to expose a top portion (2) of all sidewalls of the first electrically conductive line (MOB),
d. providing spacers (13) along each sidewall of the first electrically conductive line (MOB),
e. depositing a second dielectric layer (10) on the first dielectric layer (8) so that a top surface of the spacers (13), a top surface of the protection (11) if present, a top surface of the first electrically conductive line (MOB) if no protection (11) is present, and a top surface of the second dielectric layer (10) are coplanar,
f. etching through the second (10), the first dielectric material (8), and the gate plug (4) by using at least one of the spacers (13) as a mask, thereby forming an opening (28) exposing a top surface of the gate electrode (1), and
g. providing an electrically conductive material (14) in the opening (28), thereby forming a third electrically conductive via (VintG).

In a second aspect, the present invention relates to an integrated circuit or an intermediate in the fabrication thereof (15) obtainable by any embodiment of the first aspect.

In embodiments of the second aspect, the present invention relates to an integrated circuit or an intermediate (15) in the fabrication of an integrated circuit comprising:
a. A semiconductor structure comprising:
   i. two transistor structures (3a, 3b) separated by a dielectric separation (7), each transistor structure (3a, 3b) comprising a pMOS side (5p) of a first doping type and an nMOS side (5n) of a second doping type, each side forming a channel structure, a source portion, and a drain portion, the source portion and the drain portion being horizontally separated by said channel structure,
   ii. a gate structure on the channel structure, the gate structure comprising a gate electrode (1),
   iii. electrically conductive contacts (MOA) electrically coupled to the source portion and the drain portion of each side (5p, 5n) of each transistor structure (3a, 3b),
   iv. a first dielectric layer (8) over the two transistor structures (3a, 3b), the gate structure, and the electrically conductive contacts (MOA),
   v. a first electrically conductive line (MOB) embedded in the first dielectric layer (8), the first electrically conductive line (MOB) being arranged within a first metallization level and extending along a first direction,
   vi. a first electrically conductive via (V0A1) electrically connecting the first electrically conductive line (MOB) with a first electrically conductive contact (MOA1) on a first side (5n, 5p) of a first (3a) of the transistor structures (3a, 3b),
   vii. a second electrically conductive via (V0A2) electrically connecting the first electrically conductive line (MOB) with a second electrically conductive contact (M0A2) on a first side (5n, 5p) of a second (3b) of the transistor structures (3a, 3b),
   viii. spacers (13) along sidewalls of the first electrically conductive line (MOB),
   ix. a third electrically conductive via (VintG) through the second (10) and first dielectric material (8) and touching a spacer (13) and the gate electrode (1).

It is an advantage of embodiments of the present invention that the presence of the spacer (13) ensures a sufficient distance between M0B and VintG.

It is an advantage of embodiments of the present invention that by forming the third electrically conductive via (VintG) right after the formation of the first electrically conductive line (MOB) and before the eventual formation of second electrically conductive lines (Mintl), the aspect ratio of the third electrically conductive via (VintG) is not as high as if it was formed after the eventual formation of second electrically conductive lines (Mintl), which is easier to achieve with quality and reliability. In embodiments where step k is performed, the deep via (VintG+V5) linking the second electrically conductive lines (Mintl) to the gate electrode is formed in two steps, each step forming a part (VintG or V5) of the deep via having a reasonable aspect ratio.

It is an advantage of embodiments of the present invention that it allows the production of a scaled-down integrated circuit. In particular, they make it possible to construct a standard cell having a "four tracks" height where current technology only allows the production of a "five tracks" high standard cell.

It is an advantage of embodiments of the present invention that they enable the production of a standard cell having a height corresponding to "four tracks" wherein the metal track lines are no longer present along the standard cell vertical axis, but well along its horizontal axis. This allows standard cells obtainable by embodiments of the present invention to be "four tracks" high while actually comprising more than four tracks. Fig. 21 shows two examples of standard cells of the prior art having each metal track extending horizontally along the vertical axis of the cell. In a standard cell, the horizontal and vertical axes are defined with respect to the cell observed from above the substrate and oriented so that the transistor channel is oriented horizontally. Such cells can be referred to as HVH cells because the first level of conductive lines has its lines extending horizontally (H), and since each successive level alternates in orientation. In embodiments of the present invention, the first level of conductive lines has its lines extending vertically (V). Such cells can, therefore, be referred to as VHV cells.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change, and evolution of devices in this field, the present concepts are believed to represent substantial new and novel improvements, including departures from prior practices, resulting in the provision of more efficient, stable and reliable devices of this nature.

The above and other characteristics, features, and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Figs. 1 to 20 are schematic representations of vertical cross-sections through intermediates in the fabrication of an integrated circuit according to an embodiment of the present invention.
Fig. 21 is a top view of two schematized standard cells according to the prior art.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present (and can therefore always be replaced by "consisting of" in order to restrict the scope to said stated features) and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

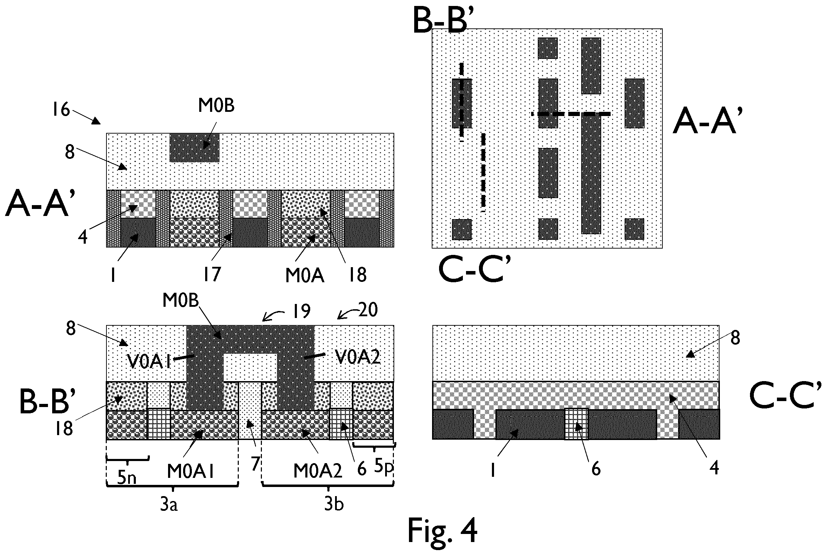

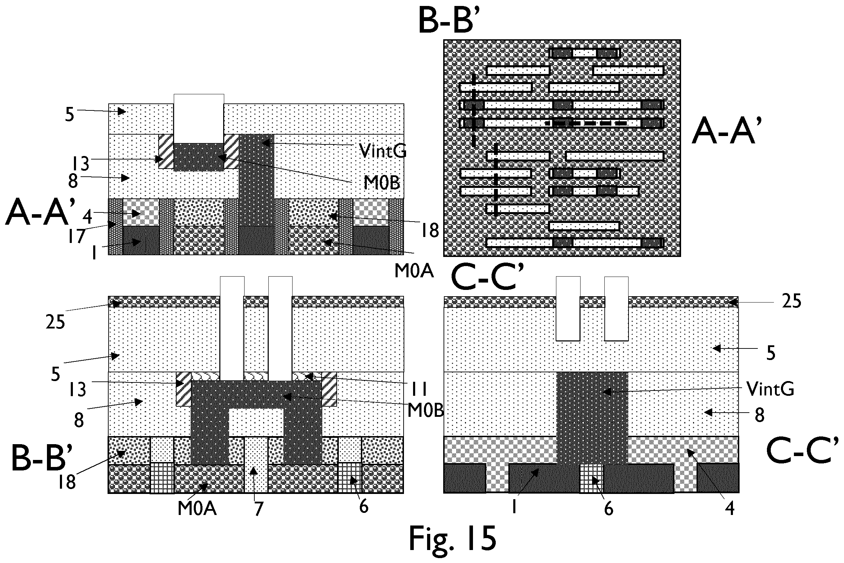

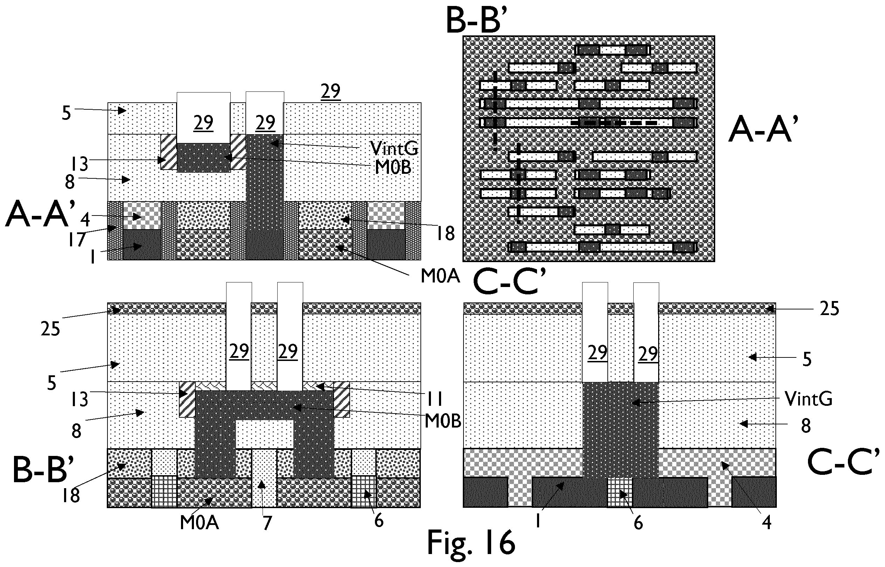

We now refer to Figs. 4 to 20.

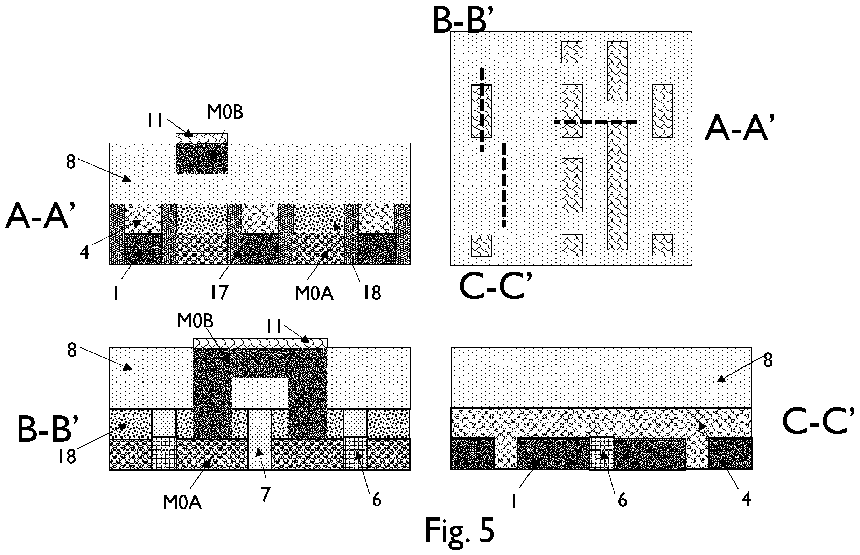

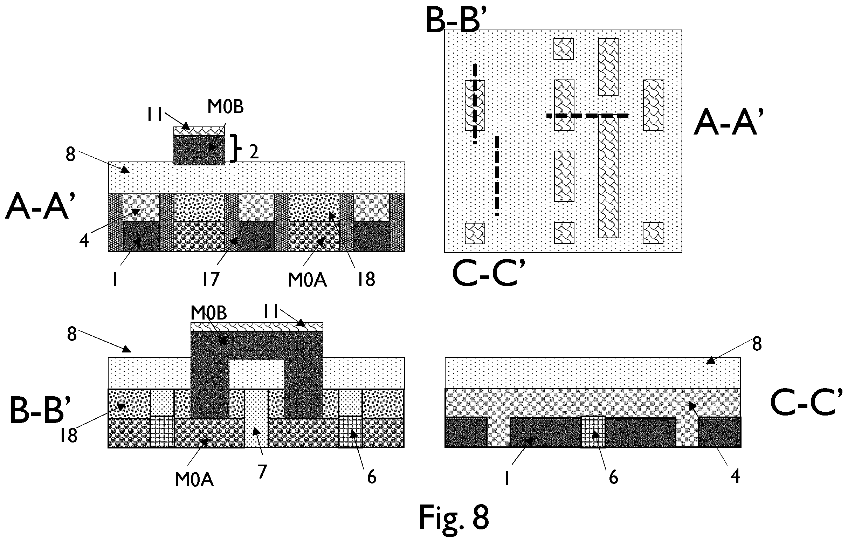

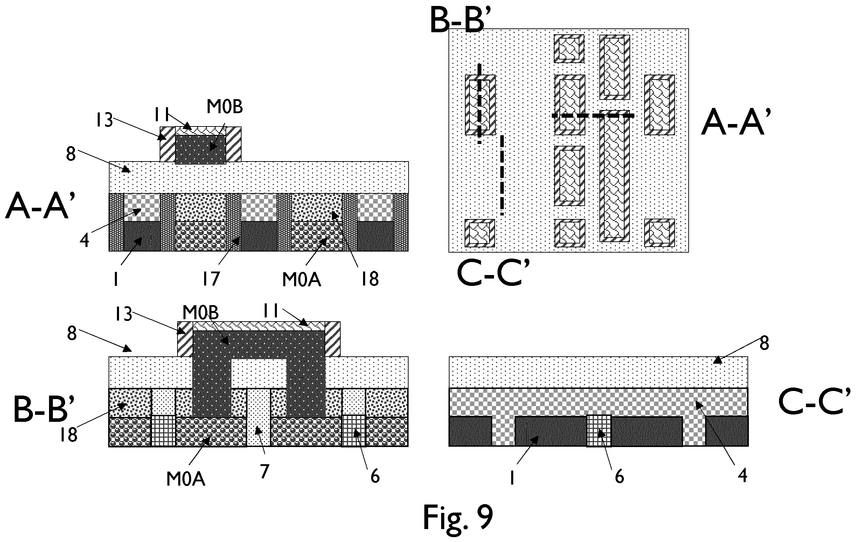

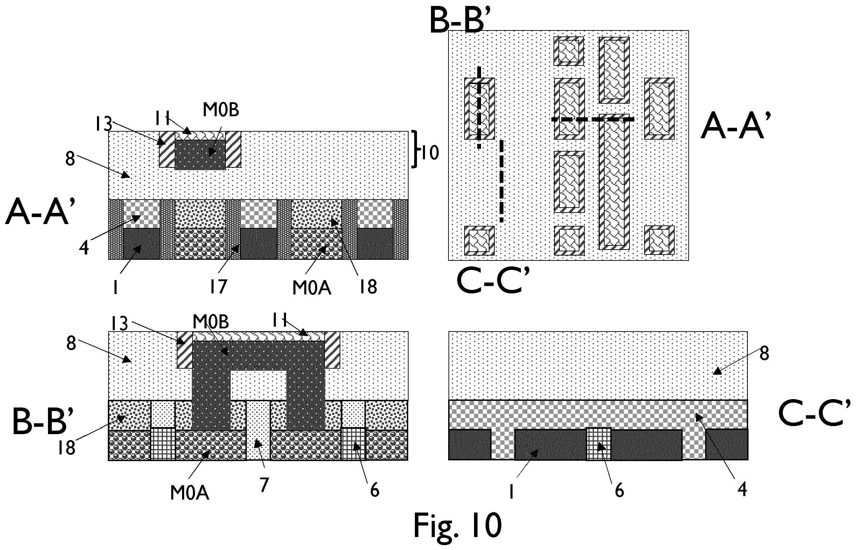

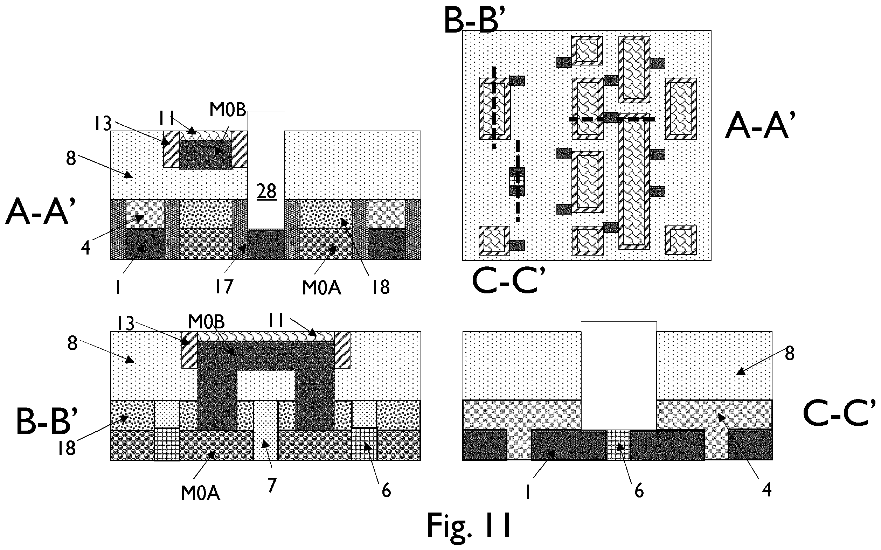

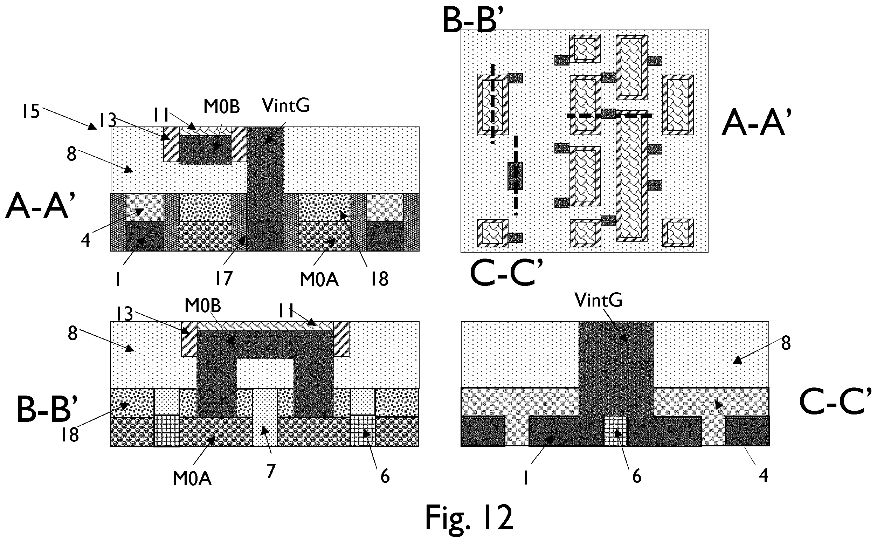

In a first aspect, the present invention relates to a method for forming an integrated circuit or an intermediate (15) in the formation thereof comprising the steps of:
a. Providing a semiconductor structure (16, Fig. 4) comprising:
   i. two transistor structures (3a, 3b) separated by a dielectric separation (7), each transistor structure (3a, 3b) comprising a pMOS side (5p) of a first doping type and an nMOS side (5n) of a second doping type, each side forming a channel structure, a source portion, and a drain portion, the source portion and the drain portion being horizontally separated by said channel structure,
   ii. a gate structure on the channel structure, the gate structure comprising a gate electrode (1) and a gate plug (4),
   iii. electrically conductive contacts (MOA) electrically coupled to the source portion and the drain portion of each side (5p, 5n) of each transistor structure (3a, 3b),
   iv. a first dielectric layer (8) over the two transistor structures (3a, 3b), the gate structure, and the electrically conductive contacts (MOA),
   v. a first electrically conductive line (MOB) embedded in the first dielectric layer (8) so that a top surface (19) of the first electrically conductive line (MOB) and a top surface (20) of the first dielectric layer (8) are coplanar, the first electrically conductive line (MOB) being arranged within a first metallization level and extending along a first direction, the first electrically conductive line (MOB) extending above at least part of each transistor structure (3a, 3b),
   vi. a first electrically conductive via (V0A1) electrically connecting the first electrically conductive line (MOB) with a first electrically conductive contact (MOA1) on a first side (5n, 5p) of a first (3a) of the transistor structures (3a, 3b),
   vii. a second electrically conductive via (V0A2) electrically connecting the first electrically conductive line (MOB) with a second electrically conductive contact (M0A2) on a first side (5n, 5p) of a second (3b) of the transistor structures (3a, 3b),
b. optionally providing a protection (11, Figs. 5-7) selectively on a top surface of the first electrically conductive line (MOB),
c. recessing the first dielectric layer (8) so as to expose a top portion (2, Fig. 8) of all sidewalls of the first electrically conductive line (MOB),
d. providing spacers (13, Fig. 9) along each sidewall of the first electrically conductive line (MOB),
e. depositing a second dielectric layer (10, Fig. 10) on the first dielectric layer (8) so that a top surface of the spacers (13), a top surface of the protection (11) if present, a top surface of the first electrically conductive line (MOB) if no protection (11) is present, and a top surface of the second dielectric layer (10) are coplanar,
f. etching through the second (10), the first dielectric material (8), and the gate plug (4) by using at least one of the spacers (13) as a mask, thereby forming an opening (28, Fig. 11) exposing a top surface of the gate electrode (1), and
g. providing an electrically conductive material in the opening (28), thereby forming a third electrically conductive via (VintG, Fig. 12).

In Fig. 4, the first electrically conductive via (VOA1) is electrically connecting the first electrically conductive line (MOB) with a first electrically conductive contact (MOA1) on a first side, here the p-type side (5p), of a first (3a) of the transistor structures (3a, 3b), while the second electrically conductive via (V0A2) is electrically connecting the first electrically conductive line (MOB) with a second electrically conductive contact (M0A2) on a first side, here an n-type side (5n), of a second (3b) of the transistor structures (3a, 3b).

An alternative starting point for the method of the first aspect is where the first electrically conductive via (V0A1) is electrically connecting the first electrically conductive line (MOB) with a first electrically conductive contact (MOA1) on a first side, here the n-type side (5n), of a first (3a) of the transistor structures (3a, 3b), while the second electrically conductive via (V0A2) is electrically connecting the first electrically conductive line (MOB) with a second electrically conductive contact (M0A2) on a first side, here also an n-type side (5n), of a second (3b) of the transistor structures (3a, 3b).

Yet another alternative starting point for the method of the first aspect is where the first electrically conductive via (VOA1) is electrically connecting the first electrically conductive line (MOB) with a first electrically conductive contact (M0A1) on a first side, here the n-type side (5n), of a first (3a) of the transistor structures (3a, 3b), while the second electrically conductive via (V0A2) is electrically connecting the first electrically conductive line (MOB) with a second electrically conductive contact (M0A2) on a first side, here a p-type side (5p), of a second (3b) of the transistor structures (3a, 3b).

Yet another alternative starting point for the method of the first aspect is where the first electrically conductive via (V0A1) is electrically connecting the first electrically conductive line (MOB) with a first electrically conductive contact (MOA1) on a first side, here the p-type side (5p), of a first (3a) of the transistor structures (3a, 3b), while the second electrically conductive via (V0A2) is electrically connecting the first electrically conductive line (MOB) with a second electrically conductive contact (M0A2) on a first side, here a p-type side (5p), of a second (3b) of the transistor structures (3a, 3b).

All these alternatives are valid starting points for performed thereon steps b and following.

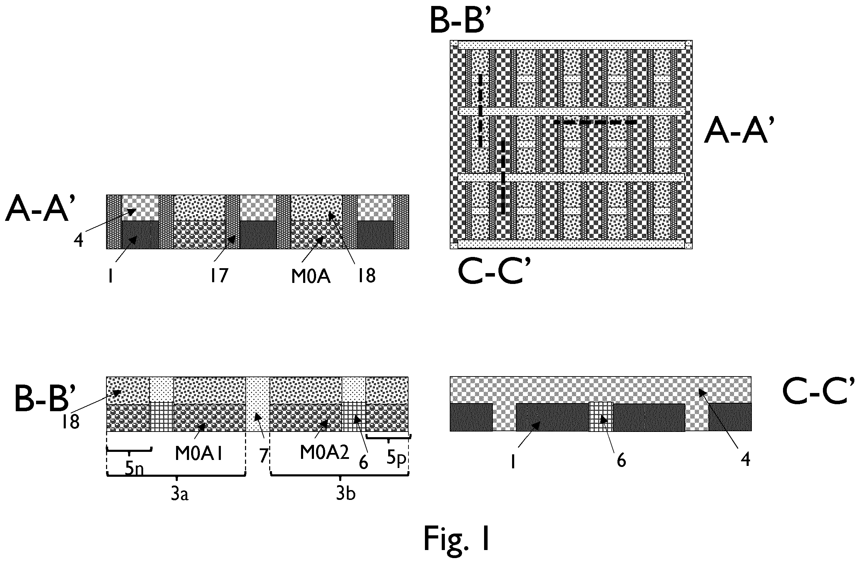

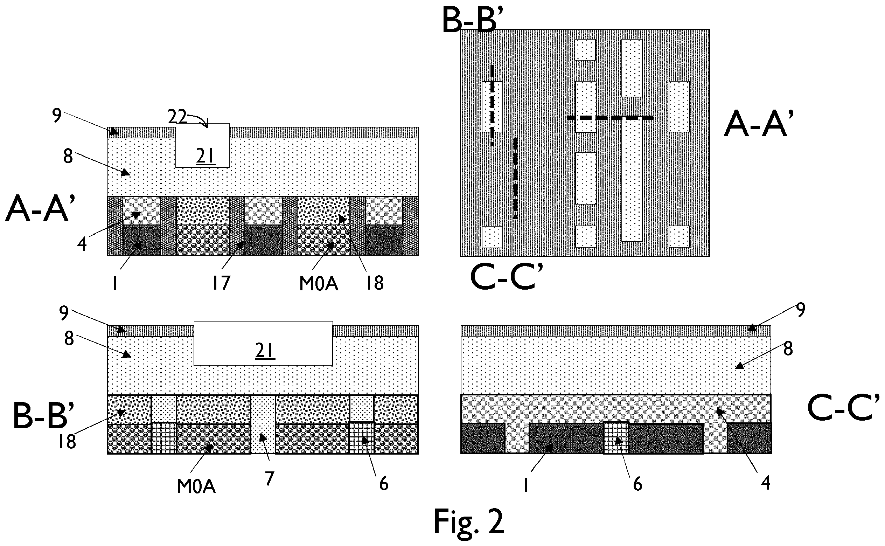

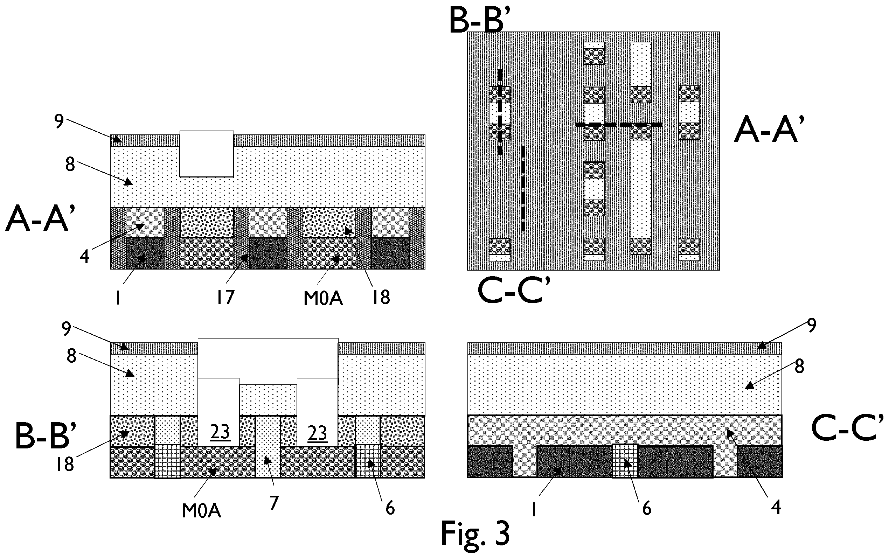

We now refer to Figs. 1 to 4. In embodiments, step a may comprise the steps of:
a1. Providing a semiconductor structure (see Fig. 1) comprising
   (i) two transistor structures (3a, 3b) separated by a dielectric separation (7), each transistor structure (3a, 3b) comprising a pMOS side (5p) of a first doping type and an nMOS side (5n) of a second doping type, each side forming a channel structure, a source portion, and a drain portion, the source portion and the drain portion being horizontally separated by said channel structure,
   (ii) a gate structure on the channel structure, the gate structure comprising a gate electrode (1) and a gate plug (4), and
   (iii) electrically conductive contacts (MOA) electrically coupled to the source portion and the drain portion of each side (5p, 5n) of each transistor structure (3a, 3b),
a2. Providing a first dielectric layer (8, Fig. 2) over the two transistor structures (3a, 3b), the gate structure, and the electrically conductive contacts (MOA),
a3. Providing a first hard mask (9, Fig. 2) over the first dielectric layer (8), the first hard mask (9) having an opening (22) having its length extending along a first direction, the opening (22) extending above at least part of each transistor structure (3a, 3b),
a4. Etching partly through the first dielectric layer (8) by using the first hard mask (9) as a mask, thereby forming a trench (21, Fig. 2) which bottom is formed by the first dielectric layer (8),
a5. Covering a central portion of the bottom with a second hard mask (not depicted), and etching two holes (23, Fig. 3), one on each side of the second hard mask, by using the first and second hard masks as masks, thereby exposing a first electrically conductive contact (MOA1) and a second electrically conductive contact (M0A2),
a6. Removing the first hard mask (9, Fig. 4) and second hard mask, and
a7. Filling both holes (23) and the trench (21) with an electrically conductive material, thereby forming a first electrically conductive line (M0B, Fig. 4), the first electrically conductive via (V0A1), and the second electrically conductive via (V0A2).

In embodiments, the two transistor structures (3a, 3b) may be two nanosheet transistor structures (3a, 3b), each nanosheet transistor structure comprising two nanosheet stacks, one stack forming the pMOS side (5p) of a first doping type, and another stack forming the nMOS side (5n) of a second doping type, each side (5p, 5n) comprising a plurality of vertically stacked nanosheets, said plurality forming a channel structure, a source portion, and a drain portion, the source portion and the drain portion being horizontally separated by said channel structure.

In preferred embodiments, the two transistor structures (3a, 3b) may be two transistor structures (3a, 3b), wherein the pMOS side (5p) of a first doping type and the nMOS side (5n) of a second doping type are separated by a dielectric wall (6), each side (5p, 5n) comprising a plurality of vertically stacked nanosheets, said plurality forming a channel structure, a source portion, and a drain portion, the source portion and the drain portion being horizontally separated by said channel structure, each nanosheet having one side touching said dielectric wall. Such transistor structures are called forksheet transistor structures. This is advantageous because it gives more space for the active devices than if nanosheets are used. Indeed, the p-n separation takes significantly less place if forksheet transistor structures (3a, 3b) are used. The reason for this is the presence of the dielectric wall (6) between the nMOS and the pMOS.

In embodiments, the dielectric separation (7) may be made of SiO₂.

In embodiments, the gate may comprise a gate metal (1) such as W. Above the gate metal (1), a gate plug (4) is typically present. For this gate plug (4), for instance, Si₃N₄ can be used. Gate spacers (17) on both sides of the gate are typically present. These gate spacers (17) can for instance be made of Si₃N₄ or silicon oxycarbide. An example of a gate structure is visible in Fig. 4 (1, 4, 17).

The source and the drain electrically conductive contacts (MOA1, M0A2) can for instance be SiGe:B (p-MOS) or Si:P (n-MOS).

Also depicted in Fig. 1, is the typical presence of a first active plug (18) above and in physical contact with the first electrically conductive contact (MOA1) and of a second active plug (18) above and in physical contact with the second electrically conductive contact (M0A2). The top surface of the active plug (18) is coplanar with the top surface of the gate spacers (17) and of the gate plug (4). The active plugs (18) are typically formed of a dielectric material such as SiO2. This SiO2 can, for instance, be deposited by plasma enhanced atomic layer deposition.

In embodiments, the first electrically conductive line (MOB) may be embedded in a dielectric material (8).

In embodiments, the first electrically conductive line (MOB) is provided as part of a set of parallel first electrically conductive lines (MOB), all arranged within a first metallization level and each extending along a same first direction.

In embodiments, the set of first electrically conductive lines (MOB) may be arranged at a pitch of from 20 to 60 nm, preferably, from 30 to 50 nm, more preferably from 35 to 45 nm, yet more preferably from 37 to 41 nm, and most preferably from 38 to 40 nm. This pitch being relatively large, there is enough space between the set of first electrically conductive lines (MOB) to eventually form the via (VintG) electrically connected with a gate (1).

The planar dielectric material (8) may for instance be SiO₂.

In embodiments, each of the first electrically conductive line (MOB) and the first and second electrically conductive vias (VOA1, V0A2) may be made of a metal independently selected from metals such as Cu, Mo, Ru, or W, amongst others.

We now refer to Figs. 5 to 7 which depict two alternative embodiments to perform step b.

In all embodiments where step b is present, the protection (11) may be a dielectric protection. In some embodiments where step b is present and where the first electrically conductive line (MOB) is made of W or Mo, the protection (11) may be selected from dielectric materials, Cu, and Ru. Cu and Ru tend to be more resistant to the recessing conditions used in step c. In particular, it is significantly more resistant than W or Mo to fluorine-based plasma.

In embodiments, as for instance illustrated in Fig. 5, step b is present, and the protection (11) may be selected from TiOx (e.g., TiO₂), silicon oxycarbide, silicon nitride, or even Cu or Ru if the first electrically conductive line (MOB) is made of W or Mo.

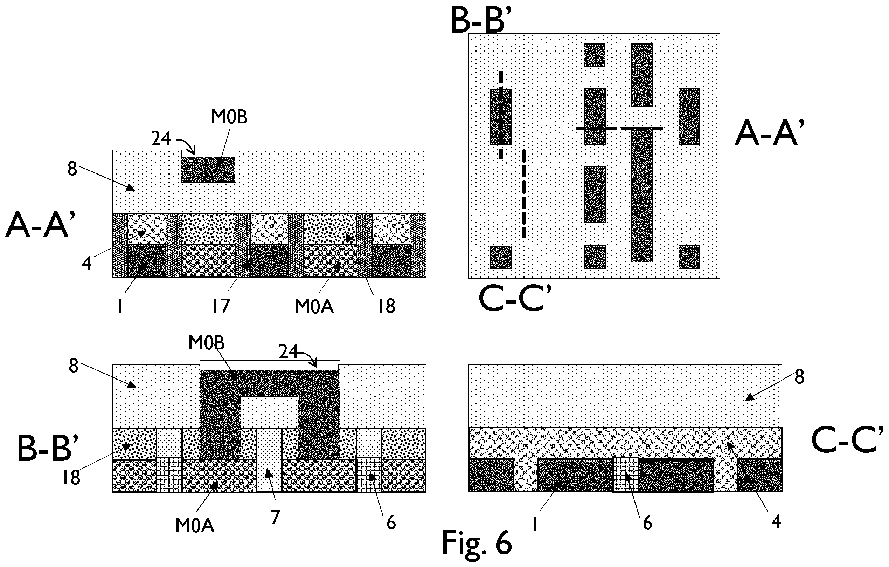

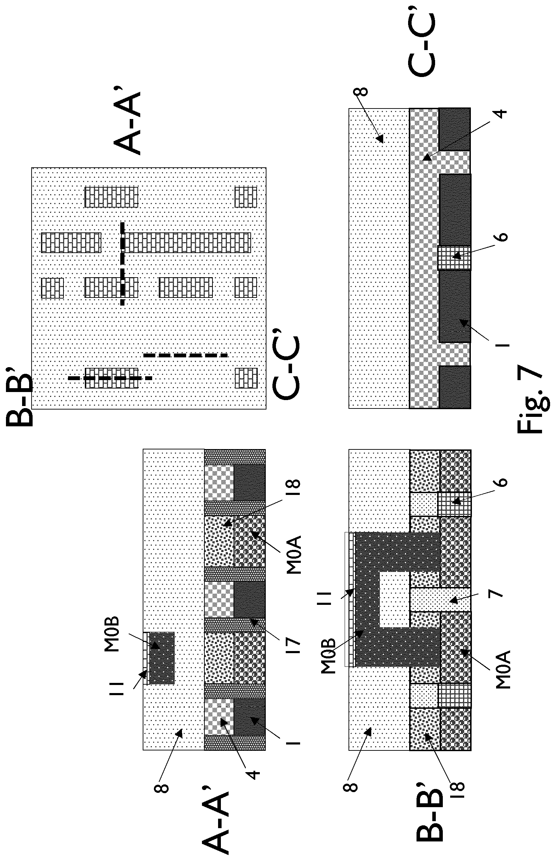

In embodiments, as for instance illustrated in Figs. 6 and 7, step b is present and comprises step b1 (Fig. 6) of partially recessing the first electrically conductive line (MOB), and the step b2 (Fig. 7) of providing the protection (11) in the recess (24) in such a way that a top surface of the protection (11) is coplanar with a top surface of the first dielectric layer (8).

In alternative embodiments, step b is present, and comprises step b1 of partially recessing the first electrically conductive line (MOB), and the step b2 of providing the protection (11) in the recess (24) in such a way that a top surface of the protection (11) is coplanar with a top surface of the first dielectric layer (8).

Step b is not necessarily present because the material forming the first electrically conductive line (MOB) is different from the material forming the first dielectric layer (8), thereby allowing finding some recessing conditions with some selectivity toward the dielectric layer (8) with respect to the first electrically conductive line (M0B). If the first electrically conductive line (MOB) is W or Mo and the dielectric layer (8) is a silicon oxide, selectivity might in some case be insufficient, at least if a fluorine-based plasma is used for step c. In such a case, the protection (11) is preferably used. If the first electrically conductive line (MOB) is Cu or Ru and the dielectric layer (8) is a silicon oxide, selectivity with typically be sufficient if a fluorine-based plasma is used. However, also in this case, the protection (11) could be used. Step c can for instance be performed with a fluorine-containing plasma, e.g., a SF₆, CF₄, CHF₃, or C₄F containing plasma.

In embodiments, the spacers (13) may be made of silicon nitride, silicon carbon nitride, silicon carbon oxynitride, or silicon oxycarbide.

In embodiments, the spacers (13) may have a thickness of from 3 to 9 nm, preferably 4 to 8 nm, more preferably 5 to 7 nm.

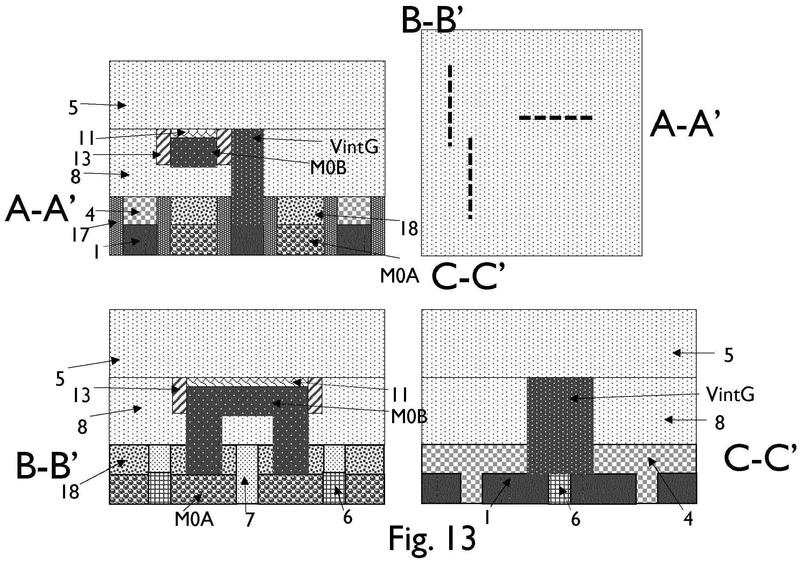

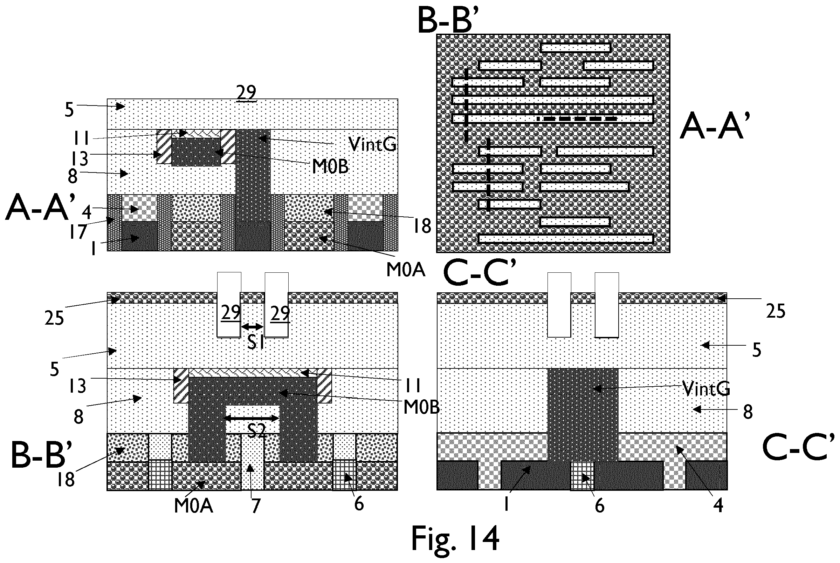

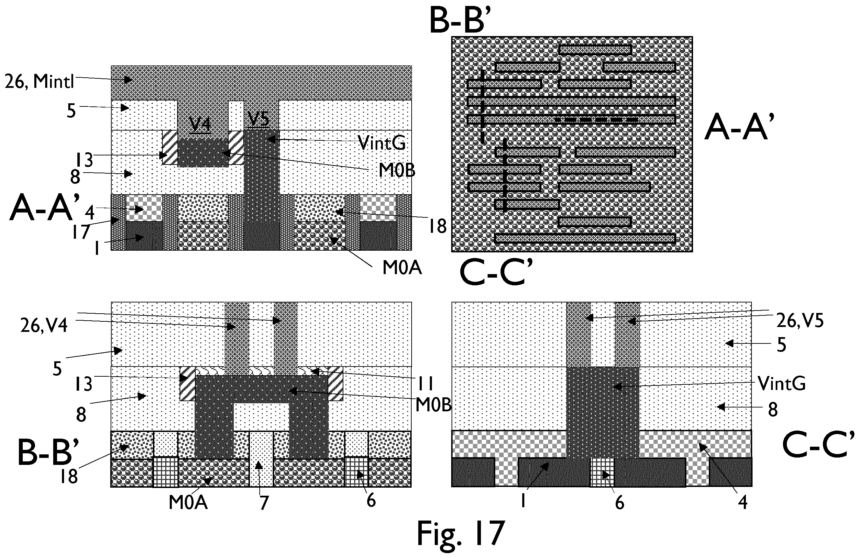

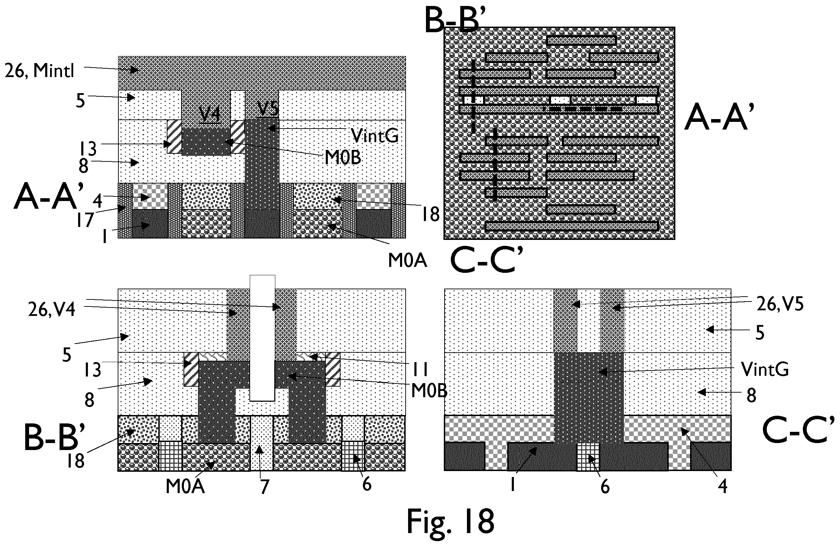

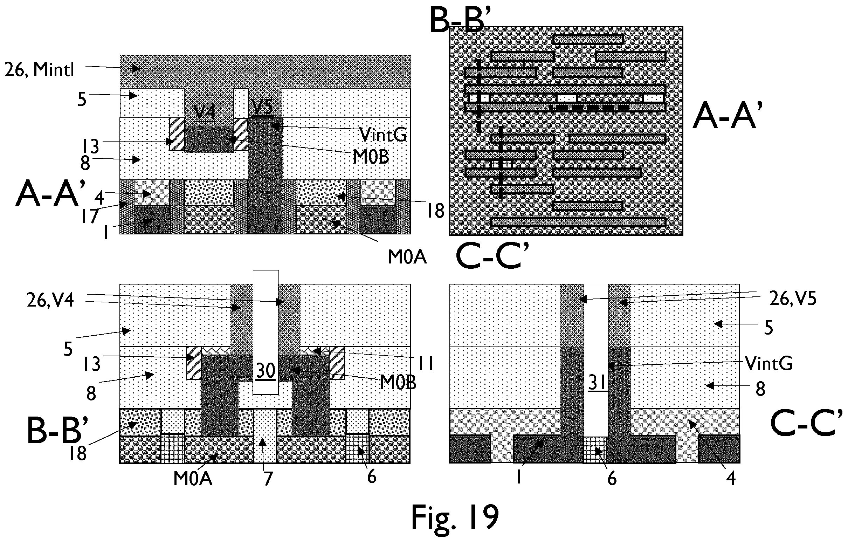

We now refer to Figs. 13 to 20. In embodiments, the method may further comprise the following steps:
h. Providing a third dielectric layer (5, Fig. 13) on the second dielectric layer (10), the top surface of the spacers (13), a top surface of the third electrically conductive via (VintG), and either the top surface of the first electrically conductive line (MOB) if step b was not performed or the top surface of the protection (11) otherwise,
i. Providing a hard mask (25, Fig. 14) on a top surface of the third dielectric layer (5), the hard mask (25) having two openings (29), a separation (S1) between both openings (29) being smaller than a space (S2) between the first electrically conductive via (VOA1) and the second electrically conductive via (V0A2), the separation (S1) being directly above the space (S2) between the first electrically conductive via (VOA1) and the second electrically conductive via (V0A2), one of said openings (29) laterally overlapping with the third electrically conductive via (VintG),
j. Etching through the third dielectric layer (5) and through the protection (11) if present by using the hard mask (25) as a mask, thereby forming two longitudinal openings (29, see Figs. 14-16) extending along a second direction, typically perpendicular to the first direction, each of said longitudinal openings (29) exposing the first electrically conductive line (MOB) and the third electrically conductive via (VintG) by means of respectively a first and a second via hole communicating with the longitudinal openings (29),
k. Providing an electrically conductive material (26, Fig. 17) in the two longitudinal openings (29), thereby forming:
   - two second electrically conductive lines (Mintl1, Mintl2) arranged within a second metallization level, and extending along the second direction, separated by the separation S1, and
   - two fourth electrically conductive vias (V4), one of them being directly physically connected to one of the two second electrically conductive lines (Mintl) and to the first electrically conductive line (MOB), the other one being directly physically connected to the other of the two second electrically conductive lines (Mintl) and to the first electrically conductive line (MOB), and
   - two fifth electrically conductive vias (V5), one of them being directly physically connected to one of the two second electrically conductive lines (Mintl) and to the third electrically conductive via (VintG), the other one being directly physically connected to the other of the two second electrically conductive lines (Mintl) and to the third electrically conductive via (VintG),
l. Etching (see Fig. 18) between both fourth electrically conductive vias (V4), through the entire thickness of the first electrically conductive line (MOB), by using both fourth electrically conductive vias as masks, thereby cutting the first electrically conductive line (MOB), thereby forming a first interruption (30) within the first electrically conductive line (MOB), and
m. Etching (see Fig. 19) between both fifth electrically conductive vias (V5), through the entire thickness of the third electrically conductive via (VintG), by using both electrically conductive vias as masks, thereby cutting the third electrically conductive via (VintG), thereby forming a second interruption (31) within the third electrically conductive via (VintG).

In embodiments, step j may comprise:
(i) etching through the third dielectric layer (5) by using the hard mask (25) as a mask, thereby forming two longitudinal openings (29, see Figs. 14) extending along a second direction, typically perpendicular to the first direction,
(ii) masking with a mask (e.g., a trilayer SOG/SOC/photoresist) sections of the two longitudinal openings that do not overlap with the first electrically conductive line (MOB),
(iii) etching through the third dielectric layer (5), and through the protection (11) if present, by using the mask provided in step (ii) and the hard mask (25) as mask, thereby exposing the first electrically conductive line (MOB) by means of a first via hole communicating with the longitudinal openings (29),
(iv) masking with a mask (e.g., a trilayer SOG/SOC/photoresist) sections of the two longitudinal openings that do not overlap with the the third electrically conductive via (VintG),
(v) etching through the third dielectric layer (5) by using the mask provided in step (iv) and the hard mask (25) as a mask, thereby exposing the third electrically conductive via (VintG) by means of second via hole communicating with the longitudinal openings (29),

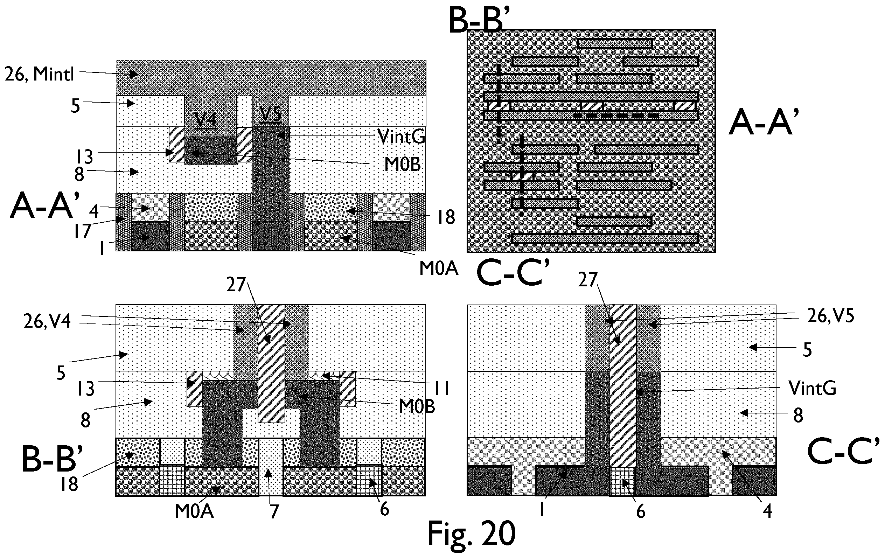

In embodiments, the method may further comprise, after step m, the step n of filling the first (30) and the second interruption (31) with a dielectric material (27, Fig. 20).

In embodiments, the method may further comprise the step o, after step m or step n, of forming:
(i) above the second metallization level, a set of third electrically conductive lines (M1l) arranged within a third metallization level, and extending along the first direction, and
(ii) a via (V1) electrically connecting a third electrically conductive line (M1l) with a second electrically conductive line (Mintl).

In embodiments, the method of the first aspect may be for forming a standard cell of the integrated circuit.

In embodiments, the standard cell may comprise four second electrically conductive lines (Mintl) and more than four third electrically conductive lines (M1l).

Steps l and m of etching respectively between both fourth electrically conductive vias (V4) and both fifth electrically conductive vias (V5) may be performed by any suitable method. For instance, if both fourth electrically conductive vias (V4) and both fifth electrically conductive vias (V5) are made of Ru, etching can be performed by plasma etching using Cl₂ and/or O₂ and Cl₂ as etchant gas in an inductively coupled plasma etching chamber.

In embodiments, the set of second electrically conductive lines (Mintl) may be arranged at a pitch of from 9 to 30 nm, preferably, from 11 to 25 nm, more preferably from 14 to 22 nm, yet more preferably from 16 to 20 nm, and most preferably from 18 to 20 nm.

In embodiments, the set of second electrically conductive lines (Mintl) may be arranged at a pitch and the width of the first interruption (30) as well as the width of the second interruption (31) are equal to 0.5 times the pitch.

In embodiments, the distance separating both fourth electrically conductive vias (V4) may be 0.5 times the pitch of the set of second electrically conductive lines (Mintl).

In embodiments, the width of each of the fourth electrically conductive vias (V4) measured along the first direction is preferably from 5 to 13 nm, more preferably from 6 to 11 nm, yet more preferably from 7 to 11 nm, and most preferably from 8 to 10 nm. Typically, the width for these two vias is 9 nm.

In embodiments, the distance separating both fourth electrically conductive vias (V4) may be preferably from 5 to 13 nm, more preferably from 6 to 11 nm, yet more preferably from 7 to 11 nm, and most preferably from 8 to 10 nm. Typically, these two vias are separated by 9 nm.

In embodiments, the first (30) and the second interruption (31) may each have a width of from 5 to 13 run, more preferably from 6 to 11 nm, yet more preferably from 7 to 11 nm, and most preferably from 8 to 10 nm. Typically, these interruptions have a width of 9 nm. Such a small interruption, let alone with perfect alignment to the gap, has up to now been very challenging. It is, however, easily achieved with the method of the present invention.

In a second aspect, the present invention relates to an integrated circuit or an intermediate (15) in the fabrication thereof obtainable by any embodiment of the first aspect.

In embodiments of the second aspect, the present invention relates to an integrated circuit or an intermediate (15) in the fabrication of an integrated circuit comprising:
a. a semiconductor structure (16) comprising:
   i. two transistor structures (3a, 3b) separated by a dielectric separation (7), each transistor structure (3a, 3b) comprising a pMOS side (5p) of a first doping type and an nMOS side (5n) of a second doping type, each side forming a channel structure, a source portion, and a drain portion, the source portion and the drain portion being horizontally separated by said channel structure,
   ii. a gate structure on the channel structure, the gate structure comprising a gate electrode (1),
   iii. electrically conductive contacts (MOA) electrically coupled to the source portion and the drain portion of each side (5p, 5n) of each transistor structure (3a, 3b),
   iv. a first dielectric layer (8) over the two transistor structures (3a, 3b), the gate structure, and the electrically conductive contacts (MOA),
   v. a first electrically conductive line (MOB) embedded in the first dielectric layer (8), the first electrically conductive line (MOB) being arranged within a first metallization level and extending along a first direction,
   vi. a first electrically conductive via (V0A1) electrically connecting the first electrically conductive line (MOB) with a first electrically conductive contact (MOA1) on a first side (5n, 5p) of a first (3a) of the transistor structures (3a, 3b),
   vii. a second electrically conductive via (V0A2) electrically connecting the first electrically conductive line (MOB) with a second electrically conductive contact (M0A2) on a first side (5n, 5p) of a second (3b) of the transistor structures (3a, 3b),
   viii. spacers (13) along sidewalls of the first electrically conductive line (MOB),
   ix. a third electrically conductive via (VintG) through the second (10) and first dielectric material (8) and touching a spacer (13) and the gate electrode (1).

In embodiments, the first electrically conductive line (MOB) extends above at least part of each transistor structure (3a, 3b) and the spacers (13) are along each sidewall of the first electrically conductive line (M0B). This is the case at least in Figs. 12 to 17. In other embodiments corresponding for instance to Figs. 18 to 20, the first electrically conductive line (MOB) comprises two parts separated by a first interruption (30) within the first electrically conductive line (MOB), a first part extending above at least part of a first transistor structure (3a) and a second part extending above at least part of a second transistor structure (3b), thereby electrically separating the first electrically conductive via (VOA1) from the second electrically conductive via (V0A2), and the spacers are along each sidewall of each part of the first electrically conductive line (MOB) except along the sidewalls facing the interruption (30).

In other embodiments, the first electrically conductive line (MOB) may comprise a gap cutting the first electrically conductive line (MOB) in two, thereby electrically separating the first electrically conductive via (VOA1) from the second electrically conductive via (V0A2).

## Claims

1. A method for forming an integrated circuit or an intermediate (15) in the formation thereof comprising the steps of:
a. Providing a semiconductor structure (16) comprising:
i. two transistor structures (3a, 3b) separated by a dielectric separation (7), each transistor structure (3a, 3b) comprising a pMOS side (5p) of a first doping type and an nMOS side (5n) of a second doping type, each side forming a channel structure, a source portion, and a drain portion, the source portion and the drain portion being horizontally separated by said channel structure,
ii. a gate structure on the channel structure, the gate structure comprising a gate electrode (1) and a gate plug (4),
iii. electrically conductive contacts (MOA) electrically coupled to the source portion and the drain portion of each side (5p, 5n) of each transistor structure (3a, 3b),
iv. a first dielectric layer (8) over the two transistor structures (3a, 3b), the gate structure, and the electrically conductive contacts (MOA),
v. a first electrically conductive line (MOB) embedded in the first dielectric layer (8) so that a top surface (19) of the first electrically conductive line (MOB) and a top surface (20) of the first dielectric layer (8) are coplanar, the first electrically conductive line (MOB) being arranged within a first metallization level and extending along a first direction, the first electrically conductive line (MOB) extending above at least part of each transistor structure (3a, 3b),
vi. a first electrically conductive via (V0A1) electrically connecting the first electrically conductive line (MOB) with a first electrically conductive contact (M0A1) on a first side (5n, 5p) of a first (3a) of the transistor structures (3a, 3b),
vii. a second electrically conductive via (V0A2) electrically connecting the first electrically conductive line (MOB) with a second electrically conductive contact (M0A2) on a first side (5n, 5p) of a second (3b) of the transistor structures (3a, 3b),
b. optionally providing a protection (11) selectively on a top surface of the first electrically conductive line (MOB),
c. recessing the first dielectric layer (8) so as to expose a top portion (2) of all sidewalls of the first electrically conductive line (MOB),
d. providing spacers (13) along each sidewall of the first electrically conductive line (MOB),
e. depositing a second dielectric layer (10) on the first dielectric layer (8) so that a top surface of the spacers (13), a top surface of the protection (11) if present, a top surface of the first electrically conductive line (MOB) if no protection (11) is present, and a top surface of the second dielectric layer (10) are coplanar,
f. etching through the second (10), the first dielectric material (8), and the gate plug (4) by using at least one of the spacers (13) as a mask, thereby forming an opening (28) exposing a top surface of the gate electrode (1), and
g. providing an electrically conductive material (14) in the opening (28), thereby forming a third electrically conductive via (VintG).

2. The method according to claim 1, wherein the two transistor structures (3a, 3b) are two transistor structures (3a, 3b), wherein the pMOS side (5p) of a first doping type and the nMOS side (5n) of a second doping type are separated by a dielectric wall (6), each side (5p, 5n) comprising a plurality of vertically stacked nanosheets, said plurality forming a channel structure, a source portion, and a drain portion, the source portion and the drain portion being horizontally separated by said channel structure, each nanosheet having one side touching said dielectric wall (6).

3. The method according to any one of the preceding claims, wherein step a comprises the steps of:
a1. Providing a semiconductor structure comprising
(i) two transistor structures (3a, 3b) separated by a dielectric separation (7), each transistor structure (3a, 3b) comprising a pMOS side (5p) of a first doping type and an nMOS side (5n) of a second doping type, each side forming a channel structure, a source portion, and a drain portion, the source portion and the drain portion being horizontally separated by said channel structure,
(ii) a gate structure on the channel structure, the gate structure comprising a gate electrode (1) and a gate plug (4), and
(iii) electrically conductive contacts (MOA) electrically coupled to the source portion and the drain portion of each side (5p, 5n) of each transistor structure (3a, 3b),
a2. Providing a first dielectric layer (8) over the two transistor structures (3a, 3b), the gate structure, and the electrically conductive contacts (MOA),
a3. Providing a first hard mask (9) over the first dielectric layer (8), the first hard mask (9) having an opening (22) having its length extending along a first direction, the opening (22) extending above at least part of each transistor structure (3a, 3b),
a4. Etching partly through the first dielectric layer (8) by using the first hard mask (9) as a mask, thereby forming a trench (21) which bottom is formed by the first dielectric layer (8),
a5. Covering a central portion of the bottom with a second hard mask, and etching two holes (23), one on each side of the second hard mask, by using the first and second hard masks as masks, thereby exposing a first electrically conductive contact (MOA1) and a second electrically conductive contact (M0A2),
a6. Removing the first hard mask (9) and second hard mask, and
a7. Filling both holes (23) and the trench (21) with an electrically conductive material, thereby forming a first electrically conductive line (MOB), the first electrically conductive via (V0A1), and the second electrically conductive via (V0A2).

4. The method according to any one of the preceding claims, wherein step b is present and the protection (11) is a dielectric protection (11).

5. The method according to claim 4, wherein step b is present and the dielectric protection (11) is TiO₂.

6. The method according to any one of claims 1 to 5, wherein step b is present and comprises step b 1 of partially recessing the first electrically conductive line (MOB), and the step b2 of providing the protection (11) in the recess (24) in such a way that a top surface of the protection (11) is coplanar with a top surface of the first dielectric layer (8).

7. The method according to any one of the preceding claims, wherein the spacers (13) are made of silicon nitride, silicon carbon nitride, silicon carbon oxynitride, or silicon oxycarbide.

8. The method according to any one of the preceding claims, wherein the spacers (13) have a thickness of from 3 to 9 nm, preferably 4 to 8 nm, more preferably 5 to 7 nm.

9. The method according to any one of the preceding claims, further comprising the following steps:
h. Providing a third dielectric layer (5) on the second dielectric layer (10), the top surface of the spacers (13), a top surface of the third electrically conductive via (VintG), and either the top surface of the first electrically conductive line (MOB) if step b was not performed or the top surface of the protection (11) otherwise,
i. Providing a hard mask (25) on a top surface of the third dielectric layer (5), the hard mask (25)having two openings (29), a separation (s1) between both openings (29) being smaller than a space (s2) between the first electrically conductive via (VOA1) and the second electrically conductive via (V0A2), the separation (s1) being directly above a space (s2) between the first electrically conductive via (VOA1) and the second electrically conductive via (V0A2), one of said openings (29) laterally overlapping with the third electrically conductive via (VintG),
j. Etching through the third dielectric layer (5) and through the protection (11) if present by using the hard mask (25) as a mask, thereby forming two longitudinal openings (29), extending along a second direction, typically perpendicular to the first direction, each of said longitudinal openings (29) exposing the first electrically conductive line (MOB) and the third electrically conductive via (VintG) by means of respectively a first and a second via hole communicating with the longitudinal openings (29),
k. Providing an electrically conductive material (26) in the two longitudinal openings (29), thereby forming thereby forming:
- two second electrically conductive lines (Mintl1, Mintl2) arranged within a second metallization level, and extending along the second direction, separated by the separation S1, and
- two fourth electrically conductive vias (V4), one of them being directly physically connected to one of the two second electrically conductive lines (Mintl) and to the first electrically conductive line (MOB), the other one being directly physically connected to the other of the two second electrically conductive lines (Mintl) and to the first electrically conductive line (MOB), and
- two fifth electrically conductive vias (V5), one of them being directly physically connected to one of the two second electrically conductive lines (Mintl) and to the third electrically conductive via (VintG), the other one being directly physically connected to the other of the two second electrically conductive lines (Mintl) and to the third electrically conductive via (VintG),
l. Etching between both fourth electrically conductive vias (V4), through the entire thickness of the first electrically conductive line (MOB), by using both fourth electrically conductive vias as masks, thereby cutting the first electrically conductive line (MOB), thereby forming a first interruption (30) within the first electrically conductive line (MOB), and
m. Etching between both fifth electrically conductive vias (V5), through the entire thickness of the third electrically conductive via (VintG), by using both electrically conductive vias as masks, thereby cutting the third electrically conductive via (VintG), thereby forming a second interruption (31) within the third electrically conductive via (VintG).

10. The method according to claim 9, further comprising, after step m, the step n of filling the first (30) and the second interruption (31) with a dielectric material (27).

11. The method according to claim 9 or claim 10, further comprising, after step m or step n, the step o of forming:
(i) above the second metallization level, a set of third electrically conductive lines (M1l) arranged within a third metallization level, and extending along the first direction, and
(ii) a via (V1) electrically connecting a third electrically conductive line (M1l) with a second electrically conductive line (Mintl).

12. The method according to any one of claims 1 to 11 for forming a standard cell of the integrated circuit.

13. The method according to claim 12 as depending on claim 11, wherein the standard cell comprises four second electrically conductive lines (Mintl) and more than four third electrically conductive lines (M1l).

14. An integrated circuit or an intermediate (15) in the fabrication of an integrated circuit comprising:
a. A semiconductor structure (16) comprising:
i. two transistor structures (3a, 3b) separated by a dielectric separation (7), each transistor structure (3a, 3b) comprising a pMOS side (5p) of a first doping type and an nMOS side (5n) of a second doping type, each side forming a channel structure, a source portion, and a drain portion, the source portion and the drain portion being horizontally separated by said channel structure,
ii. a gate structure on the channel structure, the gate structure comprising a gate electrode (1),
iii. electrically conductive contacts (MOA) electrically coupled to the source portion and the drain portion of each side (5p, 5n) of each transistor structure (3a, 3b),
iv. a first dielectric layer (8) over the two transistor structures (3a, 3b), the gate structure, and the electrically conductive contacts (MOA),
v. a first electrically conductive line (MOB) embedded in the first dielectric layer (8), the first electrically conductive line (MOB) being arranged within a first metallization level and extending along a first direction,
vi. a first electrically conductive via (V0A1) electrically connecting the first electrically conductive line (MOB) with a first electrically conductive contact (M0A1) on a first side (5n, 5p) of a first (3a) of the transistor structures (3a, 3b),
vii. a second electrically conductive via (V0A2) electrically connecting the first electrically conductive line (MOB) with a second electrically conductive contact (M0A2) on a first side (5n, 5p) of a second (3b) of the transistor structures (3a, 3b),
viii. spacers (13) along sidewalls of the first electrically conductive line (MOB),
ix. a third electrically conductive via (VintG) through the second (10) and first dielectric material (8) and touching a spacer (13) and the gate electrode (1).

15. An integrated circuit or an intermediate (15) in the fabrication of an integrated circuit according to claim 14, wherein either:
a. the first electrically conductive line (MOB) extends above at least part of each transistor structure (3a, 3b) and the spacers (13) are along each sidewall of the first electrically conductive line (MOB), or
b. the first electrically conductive line (MOB) comprises two parts separated by a first interruption (30) within the first electrically conductive line (MOB), a first part extending above at least part of a first transistor structure (3a) and a second part extending above at least part of a second transistor structure (3b), thereby electrically separating the first electrically conductive via (VOA1) from the second electrically conductive via (V0A2), and the spacers are along each sidewall of each part of the first electrically conductive line (MOB) except along the sidewalls facing the interruption (30).

## Patentansprüche

1. Ein Verfahren zur Bildung einer integrierten Schaltung oder eines Zwischenprodukts (15) bei deren Herstellung, das die folgenden Schritte umfasst:
a.- Bereitstellen einer Halbleiterstruktur (16), umfassend:
i.- zwei Transistorstrukturen (3a, 3b), die durch eine dielektrische Trennung (7) getrennt sind, wobei jede Transistorstruktur (3a, 3b) eine pMOS-Seite (5p) eines ersten Dotierungstyps und eine nMOS-Seite (5n) eines zweiten Dotierungstyps umfasst, wobei jede Seite eine Kanalstruktur, einen Quellenabschnitt und einen Abflussabschnitt bildet, wobei der Quellenabschnitt und der Abflussabschnitt horizontal durch die Kanalstruktur getrennt sind,
ii.- eine Gate-Struktur auf der Kanalstruktur, wobei die Gate-Struktur eine Gate-Elektrode (1) und einen Gate-Stopfen (4) umfasst,
iii.- elektrisch leitende Kontakte (MOA), die mit dem Quellenabschnitt und dem Abflussabschnitt jeder Seite (5p, 5n) einer jeden Transistorstruktur (3a, 3b) elektrisch gekoppelt sind,
iv.- eine erste dielektrische Schicht (8) über den beiden Transistorstrukturen (3a, 3b), der Gate-Struktur und den elektrisch leitenden Kontakten (MOA),
v.- eine erste elektrisch leitende Leitung (MOB), die in der ersten dielektrischen Schicht (8) eingebettet ist, sodass eine Oberseite (19) der ersten elektrisch leitenden Leitung (MOB) und eine Oberseite (20) der ersten dielektrischen Schicht (8) koplanar sind, wobei die erste elektrisch leitende Leitung (MOB) innerhalb einer ersten Metallisierungsebene angeordnet ist und sich entlang einer ersten Richtung erstreckt, wobei sich die erste elektrisch leitende Leitung (MOB) über zumindest einen Teil jeder Transistorstruktur (3a, 3b) erstreckt,
vi.- ein erstes elektrisch leitendes Durchgangsloch (VOA1), das die erste elektrisch leitende Leitung (MOB) mit einem ersten elektrisch leitenden Kontakt (MOA1) auf einer ersten Seite (5n, 5p) einer ersten (3a) der Transistorstrukturen (3a, 3b) elektrisch verbindet,
vii.- ein zweites elektrisch leitendes Durchgangsloch (V0A2), das die erste elektrisch leitende Leitung (MOB) mit einem zweiten elektrisch leitenden Kontakt (M0A2) auf einer ersten Seite (5n, 5p) einer zweiten (3b) der Transistorstrukturen (3a, 3b) elektrisch verbindet,
b.- gegebenenfalls Bereitstellen eines Schutzes (11) selektiv auf einer Oberseite der ersten elektrisch leitenden Leitung (MOB),
c.- Aussparung der ersten dielektrischen Schicht (8), um einen oberen Abschnitt (2) aller Seitenwände der ersten elektrisch leitenden Leitung (MOB) freizulegen,
d.- Bereitstellen von Abstandshaltern (13) entlang jeder Seitenwand der ersten elektrisch leitenden Leitung (MOB),
e.- Aufbringen einer zweiten dielektrischen Schicht (10) auf die erste dielektrische Schicht (8), sodass eine Oberseite der Abstandshalter (13), eine Oberseite des Schutzes (11), falls vorhanden, eine Oberseite der ersten elektrisch leitenden Leitung (MOB), falls kein Schutz (11) vorhanden ist, und eine Oberseite der zweiten dielektrischen Schicht (10) koplanar sind,
f.- Ätzen durch das zweite (10), das erste dielektrische Material (8) und den Gate-Stopfen (4) unter Verwendung mindestens eines der Abstandshalter (13) als Maske, wodurch eine Öffnung (28) gebildet wird, die eine Oberseite der Gate-Elektrode (1) freilegt, und
g.- Bereitstellen eines elektrisch leitenden Materials (14) in der Öffnung (28), wodurch ein drittes elektrisch leitendes Durchgangsloch (VintG) gebildet wird.

2. Das Verfahren nach Anspruch 1, wobei die beiden Transistorstrukturen (3a, 3b) zwei Transistorstrukturen (3a, 3b) sind, wobei die pMOS-Seite (5p) eines ersten Dotierungstyps und die nMOS-Seite (5n) eines zweiten Dotierungstyps durch eine dielektrische Wand (6) getrennt sind, wobei jede Seite (5p, 5n) eine Vielzahl von vertikal gestapelten Nanoblättern umfasst, wobei die Vielzahl eine Kanalstruktur, einen Quellenabschnitt und einen Abflussabschnitt bildet, wobei der Quellenabschnitt und der Abflussabschnitt horizontal durch die Kanalstruktur getrennt sind, wobei jedes Nanoblatt mit einer Seite die dielektrische Wand (6) berührt.

3. Das Verfahren nach einem der vorstehenden Ansprüche, wobei Schritt a die folgenden Schritte umfasst:
a1.- Bereitstellen einer Halbleiterstruktur, umfassend:
(i)- zwei Transistorstrukturen (3a, 3b), die durch eine dielektrische Trennung (7) getrennt sind, wobei jede Transistorstruktur (3a, 3b) eine pMOS-Seite (5p) eines ersten Dotierungstyps und eine nMOS-Seite (5n) eines zweiten Dotierungstyps umfasst, wobei jede Seite eine Kanalstruktur, einen Quellenabschnitt und einen Abflussabschnitt bildet, wobei der Quellenabschnitt und der Abflussabschnitt horizontal durch die Kanalstruktur getrennt sind,
(ii)- eine Gate-Struktur auf der Kanalstruktur, wobei die Gate-Struktur eine Gate-Elektrode (1) und einen Gate-Stopfen (4) umfasst, und
(iii)- elektrisch leitende Kontakte (MOA), die mit dem Quellenabschnitt und dem Abflussabschnitt jeder Seite (5p, 5n) einer jeden Transistorstruktur (3a, 3b) elektrisch gekoppelt sind,
a2.- Bereitstellen einer ersten dielektrischen Schicht (8) über den beiden Transistorstrukturen (3a, 3b), der Gate-Struktur und den elektrisch leitenden Kontakten (MOA),
a3.- Bereitstellen einer ersten Hartmaske (9) über der ersten dielektrischen Schicht (8), wobei die erste Hartmaske (9) eine Öffnung (22) aufweist, deren Länge sich entlang einer ersten Richtung erstreckt, wobei sich die Öffnung (22) über zumindest einen Teil jeder Transistorstruktur (3a, 3b) erstreckt,
a4.- Teilweises Ätzen durch die erste dielektrische Schicht (8) unter Verwendung der ersten Hartmaske (9) als Maske, wodurch ein Graben (21) gebildet wird, dessen Boden von der ersten dielektrischen Schicht (8) gebildet wird,
a5.- Bedecken eines mittleren Abschnitts des Bodens mit einer zweiten Hartmaske und Ätzen von zwei Löchern (23), eines auf jeder Seite der zweiten Hartmaske, unter Verwendung der ersten und zweiten Hartmaske als Masken, wodurch ein erster elektrisch leitender Kontakt (M0A1) und ein zweiter elektrisch leitender Kontakt (M0A2) freigelegt werden,
a6.- Entfernen der ersten Hartmaske (9) und der zweiten Hartmaske, und
a7.- Füllen beider Löcher (23) und des Grabens (21) mit einem elektrisch leitenden Material, wodurch eine erste elektrisch leitende Leitung (MOB), das erste elektrisch leitende Durchgangsloch (VOA1) und das zweite elektrisch leitende Durchgangsloch (V0A2) gebildet werden.

4. Das Verfahren nach einem der vorstehenden Ansprüche, wobei Schritt b vorhanden ist und der Schutz (11) ein dielektrischer Schutz (11) ist.

5. Das Verfahren nach Anspruch 4, wobei Schritt b vorhanden ist und der dielektrische Schutz (11) TiO₂ ist.

6. Das Verfahren nach einem der Ansprüche 1 bis 5, wobei Schritt b vorhanden ist und den Schritt b1 des teilweisen Aussparens der ersten elektrisch leitenden Leitung (MOB) und den Schritt b2 des Anbringens des Schutzes (11) in der Aussparung (24) derart umfasst, dass eine obere Fläche des Schutzes (11) koplanar mit einer Oberseite der ersten dielektrischen Schicht (8) ist.

7. Das Verfahren nach einem der vorstehenden Ansprüche, wobei die Abstandshalter (13) aus Siliziumnitrid, Siliziumkohlenstoffnitrid, Siliziumkohlenstoffoxynitrid oder Siliziumoxycarbid hergestellt sind.

8. Das Verfahren nach einem der vorstehenden Ansprüche, wobei die Abstandshalter (13) eine Dicke von 3 bis 9 nm, bevorzugt 4 bis 8 nm, bevorzugter 5 bis 7 nm aufweisen.

9. Das Verfahren nach einem der vorstehenden Ansprüche, das weiter die folgenden Schritte umfasst:
h.- Bereitstellen einer dritten dielektrischen Schicht (5) auf der zweiten dielektrischen Schicht (10), der Oberseite der Abstandshalter (13), einer Oberseite des dritten elektrisch leitenden Durchgangs (VintG) und entweder der Oberseite der ersten elektrisch leitenden Leitung (MOB), wenn Schritt b nicht durchgeführt wurde, oder andernfalls der Oberseite des Schutzes (11),
i.- Bereitstellen einer Hartmaske (25) auf einer Oberseite der dritten dielektrischen Schicht (5), wobei die Hartmaske (25) zwei Öffnungen (29) aufweist, wobei eine Trennung (s1) zwischen beiden Öffnungen (29) kleiner ist als ein Raum (s2) zwischen dem ersten elektrisch leitenden Durchgangsloch (VOA1) und dem zweiten elektrisch leitenden Durchgangsloch (V0A2), wobei die Trennung (s1) direkt über einem Raum (s2) zwischen dem ersten elektrisch leitenden Durchgangsloch (VOA1) und dem zweiten elektrisch leitenden Durchgangsloch (V0A2) liegt, wobei sich eine der Öffnungen (29) seitlich mit dem dritten elektrisch leitenden Durchgangsloch (VintG) überlappt,
j.- Ätzen durch die dritte dielektrische Schicht (5) und durch den Schutz (11), falls vorhanden, unter Verwendung der Hartmaske (25) als Maske, wodurch zwei Längsöffnungen (29) gebildet werden, die sich entlang einer zweiten Richtung, typischerweise senkrecht zur ersten Richtung, erstrecken, wobei jede der Längsöffnungen (29) die erste elektrisch leitende Leitung (MOB) und das dritte elektrisch leitende Durchgangsloch (VintG) mittels eines ersten bzw. eines zweiten Durchgangslochs freilegt, das mit den Längsöffnungen (29) in Verbindung steht,
k.- Bereitstellen eines elektrisch leitenden Materials (26) in den beiden Längsöffnungen (29), wodurch Folgendes gebildet wird:
- zwei zweite elektrisch leitende Leitungen (Mintl1, Mintl2), die innerhalb einer zweiten Metallisierungsebene angeordnet sind und sich entlang der zweiten Richtung erstrecken, getrennt durch die Trennung S1, und
- zwei vierte elektrisch leitende Durchgangslöcher (V4), von denen eines direkt physisch mit einer der beiden zweiten elektrisch leitenden Leitungen (Mintl) und mit der ersten elektrisch leitenden Leitung (MOB) verbunden ist, während das andere direkt physisch mit der anderen der beiden zweiten elektrisch leitenden Leitungen (Mintl) und mit der ersten elektrisch leitenden Leitung (MOB) verbunden ist, und
- zwei fünfte elektrisch leitende Durchgangslöcher (V5), von denen eines direkt physisch mit einer der beiden zweiten elektrisch leitenden Leitungen (Mintl) und mit dem dritten elektrisch leitenden Durchgangsloch (VintG) verbunden ist, während das andere direkt physisch mit der anderen der beiden zweiten elektrisch leitenden Leitungen (Mintl) und mit dem dritten elektrisch leitenden Durchgangsloch (VintG) verbunden ist,
l.- Ätzen zwischen den beiden vierten elektrisch leitenden Durchgängen (V4) durch die gesamte Dicke der ersten elektrisch leitenden Leitung (MOB) unter Verwendung der beiden vierten elektrisch leitenden Durchgangslöcher als Masken, wodurch die erste elektrisch leitende Leitung (MOB) geschnitten wird, wodurch eine erste Unterbrechung (30) innerhalb der ersten elektrisch leitenden Leitung (MOB) gebildet wird, und
m.- Ätzen zwischen den beiden fünften elektrisch leitenden Durchgangslöchern (V5) durch die gesamte Dicke des dritten elektrisch leitenden Durchgangslochs (VintG), indem beide elektrisch leitenden Durchgangslöcher als Masken verwendet werden, wodurch das dritte elektrisch leitende Durchgangsloch (VintG) geschnitten wird, wodurch eine zweite Unterbrechung (31) innerhalb des dritten elektrisch leitenden Durchgangslochs (VintG) gebildet wird.

10. Das Verfahren nach Anspruch 9, das weiter nach Schritt m den Schritt n des Füllens der ersten (30) und der zweiten Unterbrechung (31) mit einem dielektrischen Material (27) umfasst.

11. Das Verfahren nach Anspruch 9 oder Anspruch 10, das weiter nach Schritt m oder Schritt n den Schritt o umfasst, bei dem:
(i)- oberhalb der zweiten Metallisierungsebene ein Satz dritter elektrisch leitender Leitungen (M1l) gebildet wird, die innerhalb einer dritten Metallisierungsebene angeordnet sind und sich entlang der ersten Richtung erstrecken, und
(ii)- ein Durchgangsloch (V1) gebildet wird, das eine dritte elektrisch leitende Leitung (M1l) mit einer zweiten elektrisch leitenden Leitung (Mintl) elektrisch verbindet.

12. Das Verfahren nach einem der Ansprüche 1 bis 11 zur Bildung einer Standardzelle der integrierten Schaltung.

13. Das Verfahren nach Anspruch 12 in Abhängigkeit von Anspruch 11, wobei die Standardzelle vier zweite elektrisch leitende Leitungen (Mintl) und mehr als vier dritte elektrisch leitende Leitungen (M1l) umfasst.

14. Eine integrierte Schaltung oder ein Zwischenprodukt (15) bei der Herstellung einer integrierten Schaltung, umfassend:
a.- eine Halbleiterstruktur (16), umfassend:
i.- zwei Transistorstrukturen (3a, 3b), die durch eine dielektrische Trennung (7) getrennt sind, wobei jede Transistorstruktur (3a, 3b) eine pMOS-Seite (5p) eines ersten Dotierungstyps und eine nMOS-Seite (5n) eines zweiten Dotierungstyps umfasst, wobei jede Seite eine Kanalstruktur, einen Quellenabschnitt und einen Abflussabschnitt bildet, wobei der Quellenabschnitt und der Abflussabschnitt horizontal durch die Kanalstruktur getrennt sind,
ii.- eine Gate-Struktur auf der Kanalstruktur, wobei die Gate-Struktur eine Gate-Elektrode (1) umfasst,
iii.- elektrisch leitende Kontakte (MOA), die mit dem Quellenabschnitt und dem Abflussabschnitt jeder Seite (5p, 5n) einer jeden Transistorstruktur (3a, 3b) elektrisch gekoppelt sind,
iv.- eine erste dielektrische Schicht (8) über den beiden Transistorstrukturen (3a, 3b), der Gate-Struktur und den elektrisch leitenden Kontakten (MOA),
v.- eine erste elektrisch leitende Leitung (MOB), die in der ersten dielektrischen Schicht (8) eingebettet ist, wobei die erste elektrisch leitende Leitung (MOB) innerhalb einer ersten Metallisierungsebene angeordnet ist und sich entlang einer ersten Richtung erstreckt,
vi.- ein erstes elektrisch leitendes Durchgangsloch (VOA1), das die erste elektrisch leitende Leitung (MOB) mit einem ersten elektrisch leitenden Kontakt (MOA1) auf einer ersten Seite (5n, 5p) einer ersten (3a) der Transistorstrukturen (3a, 3b) elektrisch verbindet,
vii.- ein zweites elektrisch leitendes Durchgangsloch (V0A2), das die erste elektrisch leitende Leitung (MOB) mit einem zweiten elektrisch leitenden Kontakt (M0A2) auf einer ersten Seite (5n, 5p) einer zweiten (3b) der Transistorstrukturen (3a, 3b) elektrisch verbindet,
viii.- Abstandshalter (13) entlang Seitenwände der ersten elektrisch leitenden Leitung (MOB),
ix.- ein drittes elektrisch leitendes Durchgangsloch (VintG), die durch das zweite (10) und erste dielektrische Material (8) verläuft und einen Abstandshalter (13) und die Gate-Elektrode (1) berührt.

15. Eine integrierte Schaltung oder ein Zwischenprodukt (15) bei der Herstellung einer integrierten Schaltung nach Anspruch 14, wobei entweder:
a.- die erste elektrisch leitende Leitung (MOB) sich über mindestens einen Teil jeder Transistorstruktur (3a, 3b) erstreckt und die Abstandshalter (13) sich entlang jeder Seitenwand der ersten elektrisch leitenden Leitung (MOB) befinden, oder
b.- die erste elektrisch leitende Leitung (MOB) zwei Teile umfasst, die durch eine erste Unterbrechung (30) innerhalb der ersten elektrisch leitenden Leitung (MOB) getrennt sind, wobei sich ein erster Teil über mindestens einen Teil einer ersten Transistorstruktur (3a) und ein zweiter Teil über mindestens einen Teil einer zweiten Transistorstruktur (3b) erstreckt, wodurch das erste elektrisch leitende Durchgangsloch (VOA1) von dem zweiten elektrisch leitenden Durchgangsloch (V0A2) elektrisch getrennt wird, und die Abstandshalter sich entlang jeder Seitenwand jedes Teils der ersten elektrisch leitenden Leitung (MOB) befinden, außer entlang der Seitenwände, die der Unterbrechung (30) gegenüberliegen.

## Revendications

1. Un procédé de formation d'un circuit intégré ou d'un intermédiaire (15) dans la formation de celui-ci comprenant les étapes de :
a. Fournir une structure semi-conductrice (16) comprenant :
i. deux structures de transistor (3a, 3b) séparées par une séparation diélectrique (7), chaque structure de transistor (3a, 3b) comprenant un côté pMOS (5p) d'un premier type de dopage et un côté nMOS (5n) d'un second type de dopage, chaque côté formant une structure de canal, une partie source et une partie drain, la partie source et la partie drain étant horizontalement séparées par ladite structure de canal,
ii. une structure de grille sur la structure de canal, la structure de grille comprenant une électrode de grille (1) et un bouchon de grille (4),
iii. des contacts électriquement conducteurs (MOA) électriquement couplés à la partie source et à la partie drain de chaque côté (5p, 5n) de chaque structure de transistor (3a, 3b),
iv. une première couche diélectrique (8) sur les deux structures de transistor (3a, 3b), la structure de grille et les contacts électriquement conducteurs (MOA),
v. une première ligne électriquement conductrice (M0B) incorporée dans la première couche diélectrique (8) de sorte qu'une surface supérieure (19) de la première ligne électriquement conductrice (MOB) et une surface supérieure (20) de la première couche diélectrique (8) soient coplanaires, la première ligne électriquement conductrice (MOB) étant disposée dans un premier niveau de métallisation et s'étendant selon une première direction, la première ligne électriquement conductrice (MOB) s'étendant au-dessus d'au moins une partie de chaque structure de transistor (3a, 3b),
vi. un premier via électriquement conducteur (VOA1) électriquement connectant la première ligne électriquement conductrice (MOB) à un premier contact électriquement conducteur (MOA1) sur un premier côté (5n, 5p) d'une première (3a) des structures de transistor (3a, 3b),
vii. un second via électriquement conducteur (V0A2) électriquement connectant la première ligne électriquement conductrice (MOB) à un second contact électriquement conducteur (M0A2) sur un premier côté (5n, 5p) d'une seconde (3b) des structures de transistor (3a, 3b),
b. fournir éventuellement une protection (11) sélectivement sur une surface supérieure de la première ligne électriquement conductrice (MOB),
c. creuser la première couche diélectrique (8) afin d'exposer une partie supérieure (2) de toutes les parois latérales de la première ligne électriquement conductrice (MOB),
d. fournir des espaceurs (13) le long de chaque paroi latérale de la première ligne électriquement conductrice (MOB),
e. déposer une seconde couche diélectrique (10) sur la première couche diélectrique (8) de sorte qu'une surface supérieure des espaceurs (13), une surface supérieure de la protection (11) si présente, une surface supérieure de la première ligne électriquement conductrice (MOB) si aucune protection (11) n'est présente, et une surface supérieure de la seconde couche diélectrique (10) soient coplanaires,
f. graver à travers la seconde (10), la première matière diélectrique (8) et le bouchon de grille (4) en utilisant au moins un des espaceurs (13) comme masque, formant ainsi une ouverture (28) exposant une surface supérieure de l'électrode de grille (1), et
g. fournir un matériau électriquement conducteur (14) dans l'ouverture (28), formant ainsi un troisième via électriquement conducteur (VintG).

2. Le procédé selon la revendication 1, dans lequel les deux structures de transistor (3a, 3b) sont deux structures de transistor (3a, 3b), dans lequel le côté pMOS (5p) d'un premier type de dopage et le côté nMOS (5n) d'un second type de dopage sont séparés par un mur diélectrique (6), chaque côté (5p, 5n) comprenant une pluralité de nanofeuilles empilées verticalement, ladite pluralité formant une structure de canal, une partie source et une partie drain, la partie source et la partie drain étant horizontalement séparées par ladite structure de canal, chaque nanofeuille ayant un côté en contact avec ledit mur diélectrique (6).

3. Le procédé selon l'une quelconque des revendications précédentes, dans lequel l'étape a comprend les étapes de :
a1. Fournir une structure semi-conductrice comprenant
(i) deux structures de transistor (3a, 3b) séparées par une séparation diélectrique (7), chaque structure de transistor (3a, 3b) comprenant un côté pMOS (5p) d'un premier type de dopage et un côté nMOS (5n) d'un second type de dopage, chaque côté formant une structure de canal, une partie source et une partie drain, la partie source et la partie drain étant horizontalement séparées par ladite structure de canal,
(ii) une structure de grille sur la structure de canal, la structure de grille comprenant une électrode de grille (1) et un bouchon de grille (4), et
(iii) des contacts électriquement conducteurs (MOA) électriquement couplés à la partie source et à la partie drain de chaque côté (5p, 5n) de chaque structure de transistor (3a, 3b),
a2. Fournir une première couche diélectrique (8) sur les deux structures de transistor (3a, 3b), la structure de grille et les contacts électriquement conducteurs (MOA),
a3. Fournir un premier masque dur (9) sur la première couche diélectrique (8), le premier masque dur (9) ayant une ouverture (22) dont la longueur s'étend selon une première direction, l'ouverture (22) s'étendant au-dessus d'au moins une partie de chaque structure de transistor (3a, 3b),
a4. Graver partiellement à travers la première couche diélectrique (8) en utilisant le premier masque dur (9) comme masque, formant ainsi une tranchée (21) dont le fond est formé par la première couche diélectrique (8),
a5. Couvrir une partie centrale du fond avec un second masque dur, et graver deux trous (23), un de chaque côté du second masque dur, en utilisant les premier et second masques durs comme masques, exposant ainsi un premier contact électriquement conducteur (MOA1) et un second contact électriquement conducteur (M0A2),
a6. Retirer le premier masque dur (9) et le second masque dur, et
a7. Remplir les deux trous (23) et la tranchée (21) avec un matériau électriquement conducteur, formant ainsi une première ligne électriquement conductrice (MOB), le premier via électriquement conducteur (VOA1) et le second via électriquement conducteur (V0A2).

4. Le procédé selon l'une quelconque des revendications précédentes, dans lequel l'étape b est présente et la protection (11) est une protection diélectrique (11).

5. Le procédé selon la revendication 4, dans lequel l'étape b est présente et la protection diélectrique (11) est du TiO₂.

6. Le procédé selon l'une quelconque des revendications 1 à 5, dans lequel l'étape b est présente et comprend l'étape b1 de creusement partiel de la première ligne électriquement conductrice (MOB), et l'étape b2 de fourniture de la protection (11) dans le creux (24) de manière à ce qu'une surface supérieure de la protection (11) soit coplanaire avec une surface supérieure de la première couche diélectrique (8).

7. Le procédé selon l'une quelconque des revendications précédentes, dans lequel les espaceurs (13) sont faits de nitrure de silicium, de nitrure de silicium carboné, d'oxynitrure de silicium carboné ou d'oxycarbure de silicium.

8. Le procédé selon l'une quelconque des revendications précédentes, dans lequel les espaceurs (13) ont une épaisseur de 3 à 9 nm, de préférence de 4 à 8 nm, plus préférablement de 5 à 7 nm.

9. Le procédé selon l'une quelconque des revendications précédentes, comprenant en outre les étapes suivantes :
h. Fournir une troisième couche diélectrique (5) sur la seconde couche diélectrique (10), la surface supérieure des espaceurs (13), une surface supérieure du troisième via électriquement conducteur (VintG), et soit la surface supérieure de la première ligne électriquement conductrice (MOB) si l'étape b n'a pas été effectuée, soit la surface supérieure de la protection (11) autrement,
i. Fournir un masque dur (25) sur une surface supérieure de la troisième couche diélectrique (5), le masque dur (25) ayant deux ouvertures (29), une séparation (s1) entre les deux ouvertures (29) étant plus petite qu'un espace (s2) entre le premier via électriquement conducteur (VOA1) et le second via électriquement conducteur (V0A2), la séparation (s1) étant directement au-dessus d'un espace (s2) entre le premier via électriquement conducteur (VOA1) et le second via électriquement conducteur (V0A2), l'une desdites ouvertures (29) chevauchant latéralement avec le troisième via électriquement conducteur (VintG),
j. Graver à travers la troisième couche diélectrique (5) et à travers la protection (11) si présente en utilisant le masque dur (25) comme masque, formant ainsi deux ouvertures longitudinales (29), s'étendant selon une seconde direction, typiquement perpendiculaire à la première direction, chacune desdites ouvertures longitudinales (29) exposant la première ligne électriquement conductrice (MOB) et le troisième via électriquement conducteur (VintG) par le biais respectivement d'un premier et d'un second trou de via communiquant avec les ouvertures longitudinales (29),
k. Fournir un matériau électriquement conducteur (26) dans les deux ouvertures longitudinales (29), formant ainsi :
- deux secondes lignes électriquement conductrices (Mintl1, Mintl2) disposées dans un second niveau de métallisation, et s'étendant selon la seconde direction, séparées par la séparation S1, et
- deux quatrièmes vias électriquement conducteurs (V4), l'un d'eux étant directement physiquement connecté à l'une des deux secondes lignes électriquement conductrices (Mintl) et à la première ligne électriquement conductrice (MOB), l'autre étant directement physiquement connecté à l'autre des deux secondes lignes électriquement conductrices (Mintl) et à la première ligne électriquement conductrice (MOB), et
- deux cinquièmes vias électriquement conducteurs (V5), l'un d'eux étant directement physiquement connecté à l'une des deux secondes lignes électriquement conductrices (Mintl) et au troisième via électriquement conducteur (VintG), l'autre étant directement physiquement connecté à l'autre des deux secondes lignes électriquement conductrices (Mintl) et au troisième via électriquement conducteur (VintG),
l. Graver entre les deux quatrièmes vias électriquement conducteurs (V4), à travers toute l'épaisseur de la première ligne électriquement conductrice (MOB), en utilisant les deux quatrièmes vias électriquement conducteurs comme masques, coupant ainsi la première ligne électriquement conductrice (MOB), formant ainsi une première interruption (30) au sein de la première ligne électriquement conductrice (MOB), et
m. Graver entre les deux cinquièmes vias électriquement conducteurs (V5), à travers toute l'épaisseur du troisième via électriquement conducteur (VintG), en utilisant les deux vias électriquement conducteurs comme masques, coupant ainsi le troisième via électriquement conducteur (VintG), formant ainsi une seconde interruption (31) au sein du troisième via électriquement conducteur (VintG).

10. Le procédé selon la revendication 9, comprenant en outre, après l'étape m, l'étape n de remplissage de la première (30) et de la seconde interruption (31) avec un matériau diélectrique (27).

11. Le procédé selon la revendication 9 ou la revendication 10, comprenant en outre, après l'étape m ou l'étape n, l'étape o de formation :
(i) au-dessus du second niveau de métallisation, un ensemble de troisièmes lignes électriquement conductrices (M1l) disposées dans un troisième niveau de métallisation, et s'étendant selon la première direction, et
(ii) un via (V1) électriquement connectant une troisième ligne électriquement conductrice (M1l) à une seconde ligne électriquement conductrice (Mintl).

12. Le procédé selon l'une quelconque des revendications 1 à 11 pour former une cellule standard du circuit intégré.

13. Le procédé selon la revendication 12 tel que dépendant de la revendication 11, dans lequel la cellule standard comprend quatre secondes lignes électriquement conductrices (Mintl) et plus de quatre troisièmes lignes électriquement conductrices (M1l).

14. Un circuit intégré ou un intermédiaire (15) dans la fabrication d'un circuit intégré comprenant :
a. Une structure semi-conductrice (16) comprenant :
i. deux structures de transistor (3a, 3b) séparées par une séparation diélectrique (7), chaque structure de transistor (3a, 3b) comprenant un côté pMOS (5p) d'un premier type de dopage et un côté nMOS (5n) d'un second type de dopage, chaque côté formant une structure de canal, une partie source et une partie drain, la partie source et la partie drain étant horizontalement séparées par ladite structure de canal,
ii. une structure de grille sur la structure de canal, la structure de grille comprenant une électrode de grille (1),
iii. des contacts électriquement conducteurs (MOA) électriquement couplés à la partie source et à la partie drain de chaque côté (5p, 5n) de chaque structure de transistor (3a, 3b),
iv. une première couche diélectrique (8) sur les deux structures de transistor (3a, 3b), la structure de grille et les contacts électriquement conducteurs (M0A),
v. une première ligne électriquement conductrice (M0B) incorporée dans la première couche diélectrique (8), la première ligne électriquement conductrice (MOB) étant disposée dans un premier niveau de métallisation et s'étendant selon une première direction,
vi. un premier via électriquement conducteur (VOA1) électriquement connectant la première ligne électriquement conductrice (MOB) à un premier contact électriquement conducteur (MOA1) sur un premier côté (5n, 5p) d'une première (3a) des structures de transistor (3a, 3b),
vii. un second via électriquement conducteur (V0A2) électriquement connectant la première ligne électriquement conductrice (MOB) à un second contact électriquement conducteur (M0A2) sur un premier côté (5n, 5p) d'une seconde (3b) des structures de transistor (3a, 3b),
viii. des espaceurs (13) le long des parois latérales de la première ligne électriquement conductrice (MOB),
ix. un troisième via électriquement conducteur (VintG) à travers la seconde (10) et la première matière diélectrique (8) et touchant un espaceur (13) et l'électrode de grille (1).

15. Un circuit intégré ou un intermédiaire (15) dans la fabrication d'un circuit intégré selon la revendication 14, dans lequel soit :
a. la première ligne électriquement conductrice (M0B) s'étend au-dessus d'au moins une partie de chaque structure de transistor (3a, 3b) et les espaceurs (13) sont le long de chaque paroi latérale de la première ligne électriquement conductrice (M0B), ou
b. la première ligne électriquement conductrice (M0B) comprend deux parties séparées par une première interruption (30) au sein de la première ligne électriquement conductrice (MOB), une première partie s'étendant au-dessus d'au moins une partie d'une première structure de transistor (3a) et une seconde partie s'étendant au-dessus d'au moins une partie d'une seconde structure de transistor (3b), séparant ainsi électriquement le premier via électriquement conducteur (V0A1) du second via électriquement conducteur (V0A2), et les espaceurs sont le long de chaque paroi latérale de chaque partie de la première ligne électriquement conductrice (MOB) sauf le long des parois latérales faisant face à l'interruption (30).
